# EUROPEAN PATENT SPECIFICATION

(11) **EP 4 394 407 B1**
(45) Date of publication and mention of the grant of the patent: **01.04.2026**
(21) Application number: 22887441.8
(22) Date of filing: 14.10.2022
(51) Int. Cl.: G01R 31/385, G01R 19/165, G01R 31/396, G01R 31/367, H01M 10/48

(54) **BATTERY MANAGEMENT DEVICE AND OPERATION METHOD THEREOF**
BATTERIEVERWALTUNGSVORRICHTUNG UND BETRIEBSVERFAHREN DAFÜR
DISPOSITIF DE GESTION DE BATTERIE ET SON PROCÉDÉ DE FONCTIONNEMENT

(30) Priority: 28.10.2021 KR 20210146104
(43) Date of publication of application: 03.07.2024
(73) Proprietor: LG Energy Solution, Ltd., Seoul 07335 (KR)
(72) Inventor: SUN, Ju Young, Daejeon 34122 (KR); LEE, Nak Choon, Daejeon 34122 (KR); LEE, Ki Hun, Daejeon 34122 (KR); JEONG, Ju Yeon, Daejeon 34122 (KR)
(74) Representative: Plasseraud IP
(86) International application number: PCT/KR2022/015660
(87) International publication number: WO 2023/075244

(56) References cited:
- JP-A- 2003 009 405
- JP-A- 2005 114 401
- JP-A- 2007 230 398
- KR-A- 20140 065 208
- KR-B1- 101 865 365

## Description

### [TECHNICAL FIELD]

### CROSS-REFERENCE TO RELATED APPLICATION

This application claims priority to and the benefit of Korean Patent Application No. 10-2021-0146104 filed in the Korean Intellectual Property Office on October 28, 2021.

### TECHNICAL FIELD

Embodiments disclosed herein relate to a battery management apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium ion battery is attracting attention as a next-generation energy storage medium as a usage range thereof is expanded to a power source of electric vehicles.

A lithium-ion battery is implemented with multiple battery cells for power supply. A battery module is an assembly including such multiple battery cells, and generally, engagement using a bolt is made in a process of assembling the battery module. When an engagement failure may occur in such an assembly process or an engagement failure occurs in a process of using the battery module, an error may occur in a battery voltage. However, it is difficult to determine whether a cause for the error of the battery voltage is the engagement failure. KR20140065208A, on which the preamble of claims 1 and 8 is based, discloses an electric vehicle and control method thereof. KR101865365B1 discloses an apparatus and method for diagnosis of battery of portable communication terminal.

### [DISCLOSURE]

### [TECHNICAL PROBLEM]

Embodiments disclosed herein provide a battery management apparatus and an operating method thereof in which a state of a battery may be accurately determined.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to the invention includes a detecting unit configured to detect a voltage of a battery and a controller configured to determine a state of the battery based on cycle information related to a use cycle of the battery and an abnormal count value related to whether the voltage of the battery is abnormal, the abnormal count value being equal to or greater than a reference value.

The controller is further configured to define, as one use cycle, a case where a cumulative use amount of the battery reaches an entire capacity of the battery, and generate the cycle information based on a first cycle count value obtained by cumulatively counting the use cycle and a second cycle count value obtained by counting a use cycle of the battery in response to the voltage of the battery being equal to or greater than a first reference voltage or being less than or equal to a second reference voltage.

The cycle information includes a third cycle count value corresponding to a difference between the first cycle count value and the second cycle count value.

In an embodiment, the controller may be further configured to determine that an engagement failure occurs in the battery in response to the third cycle count value being less than or equal to a threshold value and the abnormal count value being equal to or greater than a reference value.

In an embodiment, the controller may be further configured to initialize the abnormal count value in response to the third cycle count value exceeding the threshold value.

In an embodiment, the controller may be further configured to set the second cycle count value to a value corresponding to the first cycle count value in response to the third cycle count value exceeding the threshold value.

In an embodiment, the controller may be further configured to generate the abnormal count value in response to the voltage of the battery being equal to or greater than a first reference voltage or being less than or equal to a second reference voltage and to set the second reference voltage to a value less than the first reference voltage.

In an embodiment, the controller may be further configured to increase the abnormal count value in response to the third cycle count value being less than or equal to a threshold value and the abnormal count value being less than a maximum value.

In an embodiment, the controller may be further configured to determine the state of the battery according to a preset period.

An operating method of a battery management apparatus according to an embodiment disclosed herein includes detecting a voltage of a battery, determining whether the voltage of the battery is abnormal, generating cycle information related to a use cycle of the battery, and determining a state of the battery based on the cycle information and an abnormal count value related to whether the voltage of the battery is abnormal, the abnormal count value being equal to or greater than a reference value.

The generating of the cycle information related to the use cycle of the battery includes defining, as one use cycle, a case where a cumulative use amount of the battery reaches an entire capacity of the battery, and generating the cycle information based on a first cycle count value obtained by cumulatively counting the use cycle and a second cycle count value obtained by counting a use cycle of the battery in response to the voltage of the battery being equal to or greater than a first reference voltage or being less than or equal to a second reference voltage.

The cycle information includes a third cycle count value corresponding to a difference between the first cycle count value and the second cycle count value.

In an embodiment, the determining of the state of the battery based on the cycle information and the abnormal count value related to whether the voltage of the battery is abnormal may include determining that an engagement failure occurs in the battery in response to the third cycle count value being less than or equal to a threshold value and the abnormal count value being equal to or greater than a reference value.

In an embodiment, the operating method may further include initializing the abnormal count value in response to the third cycle count value exceeding the threshold value.

### [ADVANTAGEOUS EFFECTS]

A battery management apparatus and an operating method thereof according to an embodiment disclosed herein may accurately determine a state of a battery.

### [DESCRIPTION OF DRAWINGS]

FIG. 1 illustrates a battery pack according to an embodiment disclosed herein.
FIG. 2 is a block diagram of a battery management apparatus according to an embodiment disclosed herein.
FIG. 3 is a view for describing an operation of a battery management apparatus, according to an embodiment disclosed herein.
FIGS. 4 and 5 are flowcharts of an operating method of a battery management system according to an embodiment disclosed herein.
FIG. 6 illustrates a computing system that executes an operating method of another battery management apparatus according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

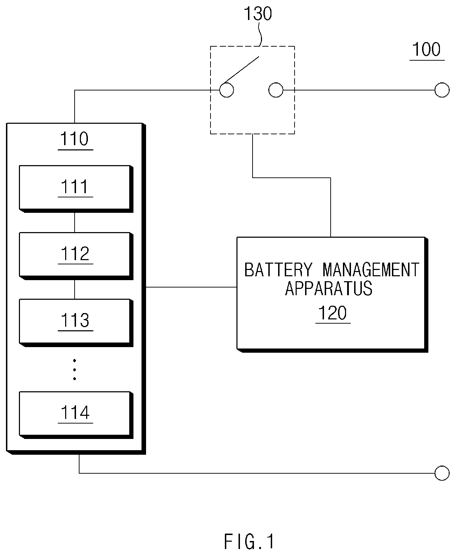

FIG. 1 illustrates a battery pack according to an embodiment disclosed herein.

Referring to FIG. 1, a battery pack 100 according to an embodiment disclosed herein may include a battery module 110, a battery management apparatus 120, and a relay 130.

The battery module 110 may include a plurality of battery cells 111, 112, 113, and 114. Although the plurality of battery cells are illustrated as four in FIG. 1, the present invention is not limited thereto, and the battery module 110 may include n battery cells (n is a natural number equal to or greater than 2). The battery module 110 may supply power to a target device (not shown). To this end, the battery module 110 may be electrically connected to the target device. Herein, the target device may include an electrical, electronic, or mechanical device that operates by receiving power from the battery pack 100 including the plurality of battery cells 111, 112, 113, and 114, and the target device may be, for example, an electric vehicle (EV), but is not limited thereto.

The plurality of battery cells 111, 112, 113, and 114 may be lithium ion (Li-ion) batteries, Li-ion polymer batteries, nickel-cadmium (Ni-Cd) batteries, nickel hydrogen (Ni-MH) batteries, etc., and may not be limited thereto. Meanwhile, although one battery module 110 is illustrated in FIG. 1, the battery module 110 may be configured in plural according to an embodiment.

The battery management apparatus 120 may manage and/or control a state and/or an operation of the battery module 110. For example, the battery management apparatus 120 may manage and/or control the states and/or operations of the plurality of battery cells 111, 112, 113, and 114 included in the battery module 110. The battery management apparatus 120 may manage charging and/or discharging of the battery module 110.

In addition, the battery management apparatus 120 may monitor a voltage, a current, a temperature, etc., of the battery module 110 and/or each of the plurality of battery cells 111, 112, 113, and 114 included in the battery module 110. A sensor or various measurement modules for monitoring performed by the battery management apparatus 120, which are not shown, may be additionally installed in the battery module 110, a charging/discharging path, any position of the battery module 110, etc. The battery management apparatus 120 may calculate a parameter indicating a state of the battery module 110, e.g., a state of charge (SoC), a state of health (SoH) etc., based on a measurement value such as monitored voltage, current, temperature, etc.

The battery management apparatus 120 may control an operation of the relay 130. For example, the battery management apparatus 120 may short-circuit the relay 130 to supply power to the target device. The battery management apparatus 120 may short-circuit the relay 130 when a charging device is connected to the battery pack 100.

The battery management apparatus 120 may calculate a cell balancing time of each of the plurality of battery cells 111, 112, 113, and 114. Herein, the cell balancing time may be defined as a time required for balancing of the battery cell. For example, the battery management apparatus 120 may calculate a cell balancing time based on an SoC, a battery capacity, and a balancing efficiency of each of the plurality of battery cells 111, 112, 113, and 114.

The battery management apparatus 120 may determine at least one cell balancing target based on the cell balancing time of each of the plurality of battery cells 111, 112, 113, and 114. According to an embodiment, the cell balancing target may be defined as a target battery cell. The battery management apparatus 120 may select at least one target battery cell based on the cell balancing time of each of the plurality of battery cells 111, 112, 113, and 114. For example, the battery management apparatus 120 may select, as at least one target battery cell, a battery cell having a cell balancing time different from those of the other battery cells by a reference value or greater, from among the plurality of battery cells 111, 112, 113, and 114.

According to various embodiments, the battery management apparatus 120 may perform cell balancing on at least one target battery cell based on a preset cell balancing time. The battery management apparatus 120 may reset at least one target battery cell upon completion of a cell balancing operation based on the preset cell balancing time.

The battery management apparatus 120 may manage states of the battery cells 111, 112, 113, 114, the battery module 110, and/or the battery pack 100. According to an embodiment, the battery management apparatus 120 may determine states of the battery module 110 and/or the battery pack 100 based on cycle information related to a use cycle of the battery module 110 and/or the battery pack 100 and an abnormal count value related to abnormality of voltages of the battery module 110 and/or the battery cells 111, 112, 113, and 114. Herein, the use cycle of the battery module 110 and/or the battery pack 100 is defined as a case where a cumulative use amount of the battery module 110 and/or the battery pack 100 reaches the total capacity of the battery module 110 and/or the battery pack 100. For example, when the cumulative use amount of the battery module 110 and/or the battery pack 100 reaches the total capacity of the battery module 110 and/or the battery pack 100, it may mean that 1 use cycle has progressed.

According to various embodiments, the battery management apparatus 120 may determine that the engagement failure occurs in the battery module 110 when a count value of a use cycle of the battery module 110 and/or the battery pack 100 reaches a threshold value (i.e., when a specific use cycle is in progress). Thus, the battery management apparatus 120 may accurately manage the state of the battery module 110 and/or the battery pack 100.

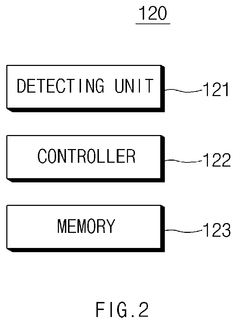

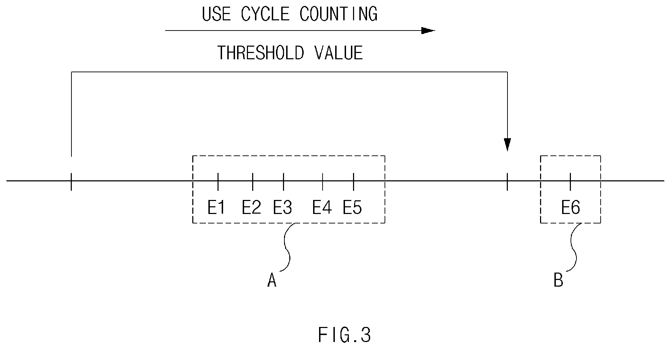

Hereinbelow, a detailed operation of the battery management apparatus 120 will be described with reference to FIGS. 2 and 3.

FIG. 2 is a block diagram of a battery management apparatus according to an embodiment disclosed herein. FIG. 3 is a view for describing an operation of a battery management apparatus, according to an embodiment disclosed herein.

First, referring to FIG. 2, the battery management apparatus 120 may include a detecting unit 121, a controller 122, and a memory 123.

The detecting unit 121 may detect voltages of the battery module 110 and/or the battery cells 111, 112, 113, and 114. According to an embodiment, the detecting unit 121 may measure or detect various physical quantities, such as current, temperature, capacity, use amount, etc., of the battery module 110 and/or the battery cells 111, 112, 113, and 114.

The controller 122 may manage the states of the battery cells 111, 112, 113, 114, the battery module 110, and/or the battery pack 100. The controller 122 may determine the states of the battery module 110 and/or the battery pack 100 based on the cycle information related to the use cycle of the battery module 110 and/or the battery pack 100 and the abnormal count value related to the abnormality of the voltages of the battery module 110 and/or the battery cells 111, 112, 113, and 114. To facilitate understanding, the following description will be made assuming that the controller 122 determines the states of the battery module 110 and/or the battery pack 100 based on the cycle information related to the use cycle of the battery module 110 and the abnormal count value related to the abnormality of the voltage of the battery module 110.

The controller 122 may manage the states of the battery cells 111, 112, 113, and 114, the battery module 110, and/or the battery pack 100 to correspond to a preset period. For example, the controller 122 may repeatedly determine the states of the battery module 110 and/or the battery pack 100 according to a preset period.

According to an embodiment, the cycle information may include a first cycle count value obtained by cumulatively counting a case where the cumulative use amount of the battery module 110 reaches the entire capacity of the battery module 110. For example, in case that the entire capacity of the battery module 110 is 100, the first cycle count value may increase by 1 each time when the cumulative use amount of the battery module 110 is 100, without being limited thereto.

According to an embodiment, the cycle information may further include a second cycle count value obtained by a corresponding use cycle of the battery module 110 when the voltage of the battery module 110 is greater than or equal to a first reference voltage or less than or equal to a second reference voltage.

The cycle information includes a third cycle count value corresponding to a difference between the first cycle count value and the second cycle count value.

The controller 122 may determine whether the voltage of the battery module 110 is abnormal. For example, the controller 122 may determine that the voltage of the battery module 110 is abnormal when the voltage of the battery module 110 is equal to or greater than the first reference voltage or less than or equal to the second reference voltage. According to an embodiment, the controller 122 may generate an abnormal count value by counting a case where the voltage of the battery module 110 is equal to or greater than the first reference voltage or less than or equal to the second reference voltage. According to an embodiment, the controller 122 may generate an abnormal count value by comparing the voltage of the battery module 110, transmitted from the detecting unit 121, with the first reference voltage and/or the second reference voltage. Herein, the second reference voltage may be set to a value less than the first reference voltage. The controller 122 may increase the abnormal count value when the third cycle count value is less than or equal to a threshold value and the abnormal count value is less than a maximum value. For example, the maximum value may be set to 255, without being limited thereto.

The controller 122 may determine the state of the battery module 110 and/or the battery pack 100 based on the abnormal count value while a count value obtained by counting a use cycle of the battery module 110 increases by the threshold value. For example, the threshold value may be set to 20, without being limited thereto. According to an embodiment, the controller 122 may determine that the engagement failure occurs in the battery module 110 when the abnormal count value is equal to or greater than a reference value while the third cycle count value reaches the threshold value. For example, the reference value may be set to 5, without being limited thereto.

As described above, the controller 122 repeatedly determines the state of the battery module 110 and/or the battery pack 100 according to a preset period, and thus may use the third cycle count value corresponding to the difference between the first cycle count value and the second cycle count value to determine the state of the battery module 110 and/or the battery pack 100 based on the abnormal count value while a count value of the use cycle of the battery module 110 increases by the threshold value. That is, the controller 122 may determine that the engagement failure occurs in the battery module 110 when the third cycle count value is less than or equal to the threshold value and the abnormal count value is equal to or greater than the reference value.

For example, referring to FIG. 3, the controller 122 may determine that the engagement failure occurs in the battery module 110 in a case A where the voltage of the battery module 110 is equal to or greater than the first reference voltage or less than or equal to the second reference voltage five times (E1, E2, E3, E4, and E5) while the count value (e.g., the third cycle count value) of the use cycle of the battery module 110 reaches the threshold value.

The controller 122 may initialize the abnormal count value when the third cycle count value exceeds the threshold value. The controller 122 may also set the second cycle count value to a value corresponding to the first cycle count value when the third cycle count value exceeds the threshold value. This is intended to determine whether the abnormal count value is equal to or greater than reference value while the use cycle of the battery module 110 increases by the threshold value again because the controller 122 repeatedly determines the state of the battery module 110 and/or the battery pack 100 according to a preset period.

For example, referring to FIG. 3, the controller 122 may determine whether the abnormal count value is equal to or greater than the reference value while the use cycle of the battery module 110 increases by the threshold value again, in a case B where E6 occurs where the voltage of the battery module 110 is equal to or greater than the first reference voltage or less than or equal to the second reference voltage after the count value of the use cycle of the battery module 110 reaches the threshold value.

The memory 123 may store various information. According to an embodiment, the memory 123 may store at least any one of the first cycle count value, the second cycle count value, the third cycle count value, and the abnormal count value.

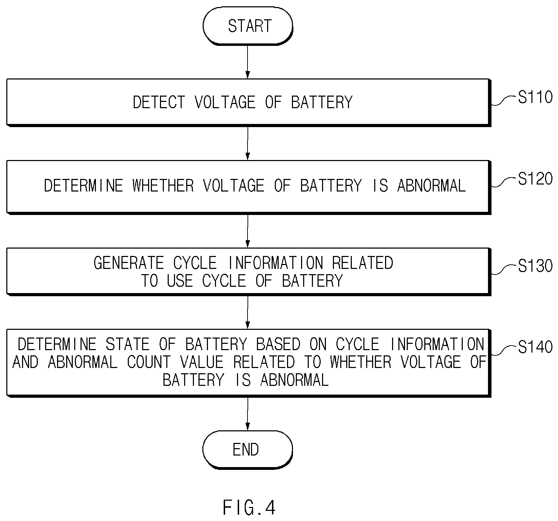

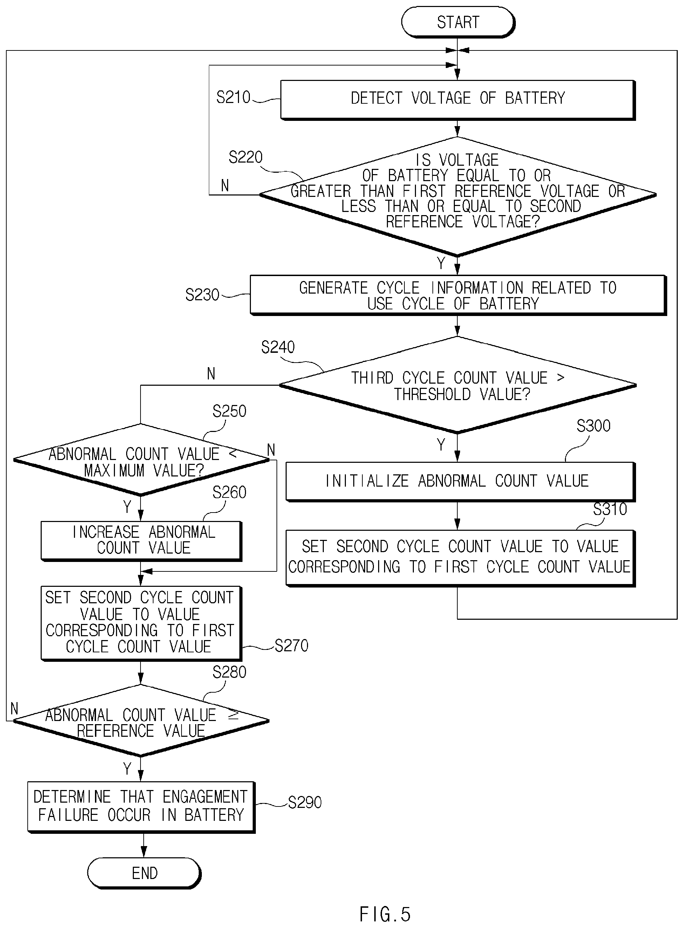

FIGS. 4 and 5 are flowcharts of an operating method of a battery management system according to an embodiment disclosed herein.

Referring to FIG. 4, the operating method of the battery management apparatus may include operation S110 of detecting a voltage of a battery, operation S120 of determining whether the voltage of the battery is abnormal, operation S130 of generating cycle information related to a use cycle of the battery, and operation S140 of determining a state of the battery based on an abnormal count value related to abnormality of the voltage of the battery.

In operation S110, the detecting unit 121 may detect the voltage of the battery module 110. The detecting unit 121 may transmit the detected voltage to the controller 122.

In operation S120, the controller 122 may determine whether the voltage of the battery module 110 is abnormal. For example, the controller 122 may determine that the voltage of the battery module 110 is abnormal when the voltage of the battery module 110 is equal to or greater than the first reference voltage or less than or equal to the second reference voltage. According to an embodiment, the controller 122 may generate an abnormal count value by counting a case where the voltage of the battery module 110 is equal to or greater than the first reference voltage or less than or equal to the second reference voltage.

In operation S130, the controller 122 may generate cycle information related to the use cycle of the battery. According to an embodiment, the cycle information may include a first cycle count value obtained by cumulatively counting a case where the cumulative use amount of the battery module 110 reaches the entire capacity of the battery module 110. According to an embodiment, the cycle information may further include a second cycle count value obtained by a corresponding use cycle of the battery module 110 when the voltage of the battery module 110 is greater than or equal to a first reference voltage or less than or equal to a second reference voltage. The cycle information further includes a third cycle count value corresponding to a difference between the first cycle count value and the second cycle count value.

While it is shown in FIG. 4 that operation S130 is performed after operation S120, the present disclosure is not limited thereto, such that operation S130 may be performed before or simultaneously with operation S110 or S120.

In operation S140, the controller 122 may determine that the engagement failure occurs in the battery module 110 when the abnormal count value is equal to or greater than a reference value while the third cycle count value reaches the threshold value. That is, the controller 122 may determine that the engagement failure occurs in the battery module 110 when the third cycle count value is less than or equal to the threshold value and the abnormal count value is equal to or greater than the reference value.

Referring to FIG. 5, the operating method of the battery management apparatus 120 may include operation S210 of detecting a voltage of a battery, operation S220 of determining whether the voltage of the battery is equal to or greater than a first reference voltage or less than or equal to a second reference voltage, operation S230 of generating cycle information related to a use cycle of the battery, operation S240 of comparing a third cycle count value with a threshold value, operation S250 of comparing an abnormal count value with a maximum value, operation S260 of increasing the abnormal count value, operation S270 of setting a second cycle count value to a value corresponding to a first cycle count value, operation S280 of comparing the abnormal count value with a reference value, operation S290 of determining that an engagement failure occurs in the battery, operation S300 of initializing the abnormal count value, and operation S310 of setting the second cycle count value to the value corresponding to the first cycle count value.

According to an embodiment, the operating method of the battery management apparatus 120 shown in FIG. 5 may be understood as an embodiment or implementation example of the operating method of the battery management apparatus 120 shown in FIG. 4.

In operation S210, the detecting unit 121 may detect the voltage of the battery module 110. The detecting unit 121 may transmit the detected voltage to the controller 122.

In operation S220, the controller 122 may determine whether the voltage of the battery module 110 is equal to or greater than the first reference voltage or less than or equal to the second reference voltage. As a result of determination, operation S230 may be performed when the voltage of the battery module 110 is equal to or greater than the first reference voltage or less than or equal to the second reference voltage, and operation S210 may be performed when the voltage of the battery module 110 is equal to or greater than the first reference voltage or less than or equal to the second reference voltage.

In operation S230, the controller 122 may generate cycle information related to the use cycle of the battery. According to an embodiment, the cycle information may include the first cycle count value, the second cycle count value, and the third cycle count value corresponding to the difference between the first cycle count value and the second cycle count value. While it is shown in FIG. 5 that operation S230 is performed after operation S220, the present disclosure is not limited thereto, such that operation S230 may be performed before or simultaneously with operation S210 or S220.

In operation S240, the controller 122 may compare the third cycle count value with the threshold value. As a result of comparison, operation S250 may be performed when the third cycle count value is less than or equal to the threshold value and operation S300 may be performed when the third cycle count value is greater than the threshold value.

In operation S250, the controller 122 may compare the abnormal count value with the maximum value. As a result of comparison, operation S260 may be performed when the abnormal count value is less than the maximum value and operation S270 may be performed when the abnormal count value is equal to or greater than the maximum value.

In operation S260, the controller 122 may increase the abnormal count value.

In operation S270, the controller 122 may also set the second cycle count value to the value corresponding to the first cycle count value.

In operation S280, the controller 122 may compare the abnormal count value with the reference value. As a result of comparison, operation S290 may be performed when the abnormal count value is equal to or greater than the reference value and operation S210 may be performed when the abnormal count value is less than the reference value.

In operation S290, the controller 122 may determine that the engagement failure occurs in the battery module 110. That is, the controller 122 may determine that the engagement failure occurs in the battery module 110 when the third cycle count value is less than or equal to the threshold value and the abnormal count value is equal to or greater than the reference value.

In operation S300, the controller 122 may initialize the abnormal count value.

In operation S310, the controller 122 may also set the second cycle count value to the value corresponding to the first cycle count value.

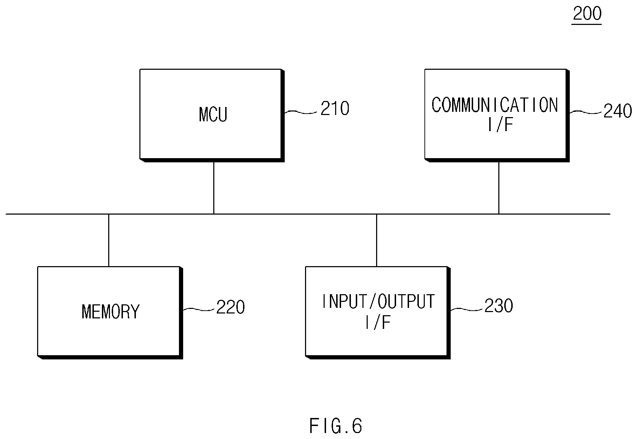

FIG. 6 illustrates a computing system that executes another battery management method, according to an embodiment disclosed herein.

Referring to FIG. 6, a computing system 200 according to an embodiment disclosed herein may include an MCU 210, a memory 220, an input/output I/F 230, and a communication I/F 240.

The MCU 210 may be a processor that executes various programs (e.g., an SoH calculation program, a cell balancing target determination program, a battery engagement failure determination program, etc.) stored in the memory 220, processes various data including an SoC, an SoH, etc., of a plurality of battery cells through these programs, executes functions of the battery management apparatus 120 described above with reference to FIGS. 1 to 3, or executes the battery management method described with reference to FIGS. 4 and 5.

The memory 220 may store various programs regarding SoH calculation of the battery cell, cell balancing target determination, a battery engagement failure determination program, etc. Moreover, the memory 220 may store various data such as SoC data, SoH data, etc., of each battery cell.

The memory 220 may be provided in plural, depending on a need. The memory 220 may be volatile memory or non-volatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., to the MCU 210.

The communication I/F 240, which is a component capable of transmitting and receiving various data to and from a server, may be various devices capable of supporting wired or wireless communication. For example, a program for SOH calculation of the battery cell or balancing target determination or various data, etc., may be transmitted and received to and from a separately provided external server through the communication I/F 240.

As such, the battery management method according to an embodiment disclosed herein may be recorded in the memory 220 and executed by the MCU 210.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. The scope of protection is defined by the appended claims.

## Claims

1. A battery management apparatus (120) comprising:
a detecting unit (121) configured to detect (S110) a voltage of a battery; and
**characterised by** a controller (122) configured to determine (S140) a state of the battery based on cycle information related to a use cycle of the battery and an abnormal count value related to whether the voltage of the battery is abnormal, the abnormal count value being equal to or greater than a reference value,
wherein the controller is further configured to:
define, as one use cycle, a case where a cumulative use amount of the battery reaches an entire capacity of the battery, and generate the cycle information based on a first cycle count value obtained by cumulatively counting the use cycle and a second cycle count value obtained by counting a use cycle of the battery in response to the voltage of the battery being equal to or greater than a first reference voltage or being less than or equal to a second reference voltage,
wherein the cycle information comprises a third cycle count value corresponding to a difference between the first cycle count value and the second cycle count value.

2. The battery management apparatus of claim 1, wherein the controller is further configured to determine (S290) that an engagement failure occurs in the battery in response to the third cycle count value being less than or equal to a threshold value and the abnormal count value being equal to or greater than the reference value, whereby the engagement failure occurs in a process of assembling or using the battery.

3. The battery management apparatus of claim 1, wherein the controller is further configured to initialize (S300) the abnormal count value in response to the third cycle count value exceeding a threshold value.

4. The battery management apparatus of claim 1, wherein the controller is further configured to set (S270) the second cycle count value to a value corresponding to the first cycle count value in response to the third cycle count value exceeding a threshold value.

5. The battery management apparatus of claim 1, wherein the controller is further configured to:
generate the abnormal count value in response to the voltage of the battery being equal to or greater than the first reference voltage or being less than or equal to the second reference voltage; and
set the second reference voltage to a value less than the first reference voltage.

6. The battery management apparatus of claim 1, wherein the controller is further configured to increase (S260) the abnormal count value in response to the third cycle count value being less than or equal to a threshold value and the abnormal count value being less than a maximum value.

7. The battery management apparatus of claim 1, wherein the controller is further configured to determine the state of the battery according to a preset period.

8. An operating method of a battery management apparatus, the operating method comprising:
detecting (S110) a voltage of a battery;
determining (S120) whether the voltage of the battery is abnormal;
the method being **characterised by** the following steps:
generating (S130) cycle information related to a use cycle of the battery; and
determining (S140) a state of the battery based on the cycle information and an abnormal count value related to whether the voltage of the battery is abnormal, the abnormal count value being equal to or greater than a reference value,
wherein the generating of the cycle information related to the use cycle of the battery comprises defining, as one use cycle, a case where a cumulative use amount of the battery reaches an entire capacity of the battery, and generating the cycle information based on a first cycle count value obtained by cumulatively counting the use cycle and a second cycle count value obtained by counting a use cycle of the battery in response to the voltage of the battery being equal to or greater than a first reference voltage or being less than or equal to a second reference voltage,
wherein the cycle information comprises a third cycle count value corresponding to a difference between the first cycle count value and the second cycle count value.

9. The operating method of claim 8, wherein the determining of the state of the battery based on the cycle information and the abnormal count value related to whether the voltage of the battery is abnormal comprises:
determining (S240) that an engagement failure occurs in the battery in response to the third cycle count value being less than or equal to a threshold value and the abnormal count value being equal to or greater than the reference value, whereby the engagement failure occurs in a process of assembling or using the battery.

10. The operating method of claim 8, further comprising initializing (S300) the abnormal count value in response to the third cycle count value exceeding a threshold value.

## Patentansprüche

1. Batteriemanagementvorrichtung (120), umfassend:
eine Detektionseinheit (121), welche dazu eingerichtet ist, eine Spannung einer Batterie zu detektieren (S110); und
**gekennzeichnet durch**
eine Steuereinrichtung (122), welche dazu eingerichtet ist, einen Zustand der Batterie auf Grundlage von Zyklusinformationen, welche sich auf einen Nutzungszyklus der Batterie beziehen, und eines Anomaliezählwerts, welcher sich darauf bezieht, ob die Spannung der Batterie abnormal ist, zu bestimmen (S140), wobei der Anomaliezählwert gleich wie oder größer als ein Referenzwert ist,
wobei die Steuereinrichtung ferner dazu eingerichtet ist:
einen Fall, in welchem eine kumulative Nutzungsmenge der Batterie eine Gesamtkapazität der Batterie erreicht, als einen Nutzungszyklus zu definieren und die Zyklusinformationen auf Grundlage eines durch ein kumulatives Zählen des Nutzungszyklus erhaltenen ersten Zykluszählwerts und eines durch ein Zählen eines Nutzungszyklus der Batterie erhaltenen zweiten Zykluszählwerts in Reaktion darauf zu erzeugen, dass die Spannung der Batterie gleich wie oder größer als eine erste Referenzspannung ist oder kleiner als oder gleich wie eine zweite Referenzspannung ist,
wobei die Zyklusinformationen einen dritten Zykluszählwert umfassen, welcher einer Differenz zwischen dem ersten Zykluszählwert und dem zweiten Zykluszählwert entspricht.

2. Batteriemanagementvorrichtung nach Anspruch 1, wobei die Steuereinrichtung ferner dazu eingerichtet ist, in Reaktion darauf, dass der dritte Zykluszählwert kleiner als oder gleich wie ein Schwellenwert ist und der Anomaliezählwert gleich wie oder größer als der Referenzwert ist, zu bestimmen (S290), dass ein Eingriffsfehler in der Batterie auftritt, wobei der Eingriffsfehler in einem Prozess einer Montage oder einer Nutzung der Batterie auftritt.

3. Batteriemanagementvorrichtung nach Anspruch 1, wobei die Steuereinrichtung ferner dazu eingerichtet ist, den Anomaliezählwert in Reaktion darauf zu initialisieren (S300), dass der dritte Zykluszählwert einen Schwellenwert überschreitet.

4. Batteriemanagementvorrichtung nach Anspruch 1, wobei die Steuereinrichtung ferner dazu eingerichtet ist, den zweiten Zykluszählwert in Reaktion darauf, dass der dritte Zykluszählwert einen Schwellenwert überschreitet, auf einen Wert einzustellen (S270), welcher dem ersten Zykluszählwert entspricht.

5. Batteriemanagementvorrichtung nach Anspruch 1, wobei die Steuereinrichtung ferner dazu eingerichtet ist:
den Anomaliezählwert in Reaktion darauf zu erzeugen, dass die Spannung der Batterie gleich wie oder größer als die erste Referenzspannung ist oder kleiner als oder gleich wie die zweite Referenzspannung ist; und
die zweite Referenzspannung auf einen Wert einzustellen, welcher kleiner ist als die erste Referenzspannung.

6. Batteriemanagementvorrichtung nach Anspruch 1, wobei die Steuereinrichtung ferner dazu eingerichtet ist, den Anomaliezählwert in Reaktion darauf zu erhöhen (S260), dass der dritte Zykluszählwert kleiner als oder gleich wie ein Schwellenwert ist und der Anomaliezählwert kleiner als ein Maximalwert ist.

7. Batteriemanagementvorrichtung nach Anspruch 1, wobei die Steuereinrichtung ferner dazu eingerichtet ist, den Zustand der Batterie gemäß einem vorgegebenen Zeitraum zu bestimmen.

8. Betriebsverfahren einer Batteriemanagementvorrichtung, wobei das Betriebsverfahren umfasst:
Detektieren (S110) einer Spannung einer Batterie;
Bestimmen (S120), ob die Spannung der Batterie abnormal ist;
wobei das Verfahren durch die folgenden Schritte gekennzeichnet ist:
Erzeugen (S130) von Zyklusinformationen, welche sich auf einen Nutzungszyklus der Batterie beziehen; und
Bestimmen (S140) eines Zustands der Batterie auf Grundlage der Zyklusinformationen und eines Anomaliezählwerts, welcher sich darauf bezieht, ob die Spannung der Batterie abnormal ist, wobei der Anomaliezählwert gleich wie oder größer als ein Referenzwert ist,
wobei das Erzeugen der Zyklusinformationen, welche sich auf den Nutzungszyklus der Batterie beziehen, ein Definieren eines Falls, in welchem eine kumulative Nutzungsmenge der Batterie eine Gesamtkapazität der Batterie erreicht, als einen Nutzungszyklus und ein Erzeugen der Zyklusinformationen auf Grundlage eines durch ein kumulatives Zählen des Nutzungszyklus erhaltenen ersten Zykluszählwerts und eines durch ein Zählen eines Nutzungszyklus der Batterie erhaltenen zweiten Zykluszählwerts in Reaktion darauf umfasst, dass die Spannung der Batterie gleich wie oder größer als eine erste Referenzspannung ist oder kleiner als oder gleich wie eine zweite Referenzspannung ist,
wobei die Zyklusinformationen einen dritten Zykluszählwert umfassen, welcher einer Differenz zwischen dem ersten Zykluszählwert und dem zweiten Zykluszählwert entspricht.

9. Betriebsverfahren nach Anspruch 8, wobei das Bestimmen des Zustands der Batterie auf Grundlage der Zyklusinformationen und des Anomaliezählwerts, welcher sich darauf bezieht, ob die Spannung der Batterie abnormal ist, umfasst:
Bestimmen (S240), dass ein Eingriffsfehler in der Batterie auftritt, in Reaktion darauf, dass der dritte Zykluszählwert kleiner als oder gleich wie ein Schwellenwert ist und der Anomaliezählwert gleich wie oder größer als der Referenzwert ist, wobei der Eingriffsfehler in einem Prozess einer Montage oder einer Nutzung der Batterie auftritt.

10. Betriebsverfahren nach Anspruch 8, ferner umfassend ein Initialisieren (S300) des Anomaliezählwerts in Reaktion darauf, dass der dritte Zykluszählwert einen Schwellenwert überschreitet.

## Revendications

1. Appareil de gestion de batterie (120) comprenant :
une unité de détection (121) configurée pour détecter (S110) une tension d'une batterie ; et
**caractérisé par**
un dispositif de commande (122) configuré pour déterminer (S140) un état de la batterie sur la base d'informations de cycle liées à un cycle d'utilisation de la batterie et d'une valeur de comptage anormale liée au fait que la tension de la batterie est anormale ou non, la valeur de comptage anormale étant égale ou supérieure à une valeur de référence,
dans lequel le dispositif de commande est en outre configuré pour :
définir, comme un cycle d'utilisation, un cas où une quantité d'utilisation cumulée de la batterie atteint une capacité totale de la batterie, et générer les informations de cycle sur la base d'une première valeur de comptage de cycle obtenue en comptant de manière cumulée le cycle d'utilisation et d'une deuxième valeur de comptage de cycle obtenue en comptant un cycle d'utilisation de la batterie en réponse à la tension de la batterie qui est égale ou supérieure à une première tension de référence ou qui est inférieure ou égale à une seconde tension de référence,
dans lequel les informations de cycle comprennent une troisième valeur de comptage de cycle correspondant à une différence entre la première valeur de comptage de cycle et la deuxième valeur de comptage de cycle.

2. Appareil de gestion de batterie selon la revendication 1, dans lequel le dispositif de commande est en outre configuré pour déterminer (S290) qu'une défaillance de mise en prise se produit dans la batterie en réponse à la troisième valeur de comptage de cycle qui est inférieure ou égale à une valeur seuil et à la valeur de comptage anormale qui est égale ou supérieure à la valeur de référence, la défaillance de mise en prise se produisant lors d'un processus d'assemblage ou d'utilisation de la batterie.

3. Appareil de gestion de batterie selon la revendication 1, dans lequel le dispositif de commande est en outre configuré pour initialiser (S300) la valeur de comptage anormale en réponse à la troisième valeur de comptage de cycle qui dépasse une valeur seuil.

4. Appareil de gestion de batterie selon la revendication 1, dans lequel le dispositif de commande est en outre configuré pour établir (S270) la deuxième valeur de comptage de cycle à une valeur correspondant à la première valeur de comptage de cycle en réponse à la troisième valeur de comptage de cycle qui dépasse une valeur seuil.

5. Appareil de gestion de batterie selon la revendication 1, dans lequel le dispositif de commande est en outre configuré pour :
générer la valeur de comptage anormale en réponse à la tension de la batterie qui est égale ou supérieure à la première tension de référence ou qui est inférieure ou égale à la seconde tension de référence ; et
établir la seconde tension de référence à une valeur inférieure à la première tension de référence.

6. Appareil de gestion de batterie selon la revendication 1, dans lequel le dispositif de commande est en outre configuré pour augmenter (S260) la valeur de comptage anormale en réponse à la troisième valeur de comptage de cycle qui est inférieure ou égale à une valeur seuil et à la valeur de comptage anormale qui est inférieure à une valeur maximale.

7. Appareil de gestion de batterie selon la revendication 1, dans lequel le dispositif de commande est en outre configuré pour déterminer l'état de la batterie conformément à une période préétablie.

8. Procédé de fonctionnement d'un appareil de gestion de batterie, le procédé de fonctionnement comprenant :
la détection (S110) d'une tension d'une batterie ;
la détermination (S120) si la tension de la batterie est anormale ;
le procédé étant **caractérisé par** les étapes suivantes :
la génération (S130) d'informations de cycle liées à un cycle d'utilisation de la batterie ; et
la détermination (S140) d'un état de la batterie sur la base des informations de cycle et d'une valeur de comptage anormale liée au fait que la tension de la batterie est anormale ou non, la valeur de comptage anormale étant égale ou supérieure à une valeur de référence,
dans lequel la génération des informations de cycle liées au cycle d'utilisation de la batterie comprend la définition, comme un cycle d'utilisation, d'un cas où une quantité d'utilisation cumulée de la batterie atteint une capacité totale de la batterie, et la génération des informations de cycle sur la base d'une première valeur de comptage de cycle obtenue en comptant de manière cumulée le cycle d'utilisation et d'une deuxième valeur de comptage de cycle obtenue en comptant un cycle d'utilisation de la batterie en réponse à la tension de la batterie qui est égale ou supérieure à une première tension de référence ou qui est inférieure ou égale à une seconde tension de référence,
dans lequel les informations de cycle comprennent une troisième valeur de comptage de cycle correspondant à une différence entre la première valeur de comptage de cycle et la deuxième valeur de comptage de cycle.

9. Procédé de fonctionnement selon la revendication 8, dans lequel la détermination de l'état de la batterie sur la base des informations de cycle et de la valeur de comptage anormale liée au fait que la tension de la batterie est anormale ou non comprend :
la détermination (S240) qu'une défaillance de mise en prise se produit dans la batterie en réponse à la troisième valeur de comptage de cycle qui est inférieure ou égale à une valeur seuil et à la valeur de comptage anormale qui est égale ou supérieure à la valeur de référence, la défaillance de mise en prise se produisant lors d'un processus d'assemblage ou d'utilisation de la batterie.

10. Procédé de fonctionnement selon la revendication 8, comprenant en outre l'initialisation (S300) de la valeur de comptage anormale en réponse à la troisième valeur de comptage de cycle qui dépasse une valeur seuil.
